# EUROPEAN PATENT APPLICATION

(11) **EP 4 834 847 A1**
(43) Date of publication of application: **04.11.2026**
(21) Application number: 24912960.2
(22) Date of filing: 25.12.2024
(51) Int. Cl.: C01G 49/00, C04B 35/26, H01F 1/34, H05K 9/00

(54) **MAGNETOPLUMBITE-TYPE HEXAGONAL FERRITE POWDER, FERRITE RESIN COMPOSITE MATERIAL, FERRITE RESIN COMPOSITE, AND ELECTROMAGNETIC WAVE ABSORBER**

(30) Priority: 27.12.2023 JP 2023221337
(71) Applicant: Powdertech Co., Ltd., Kashiwa-shi, Chiba 277-8557 (JP)
(72) Inventor: NOZAWA, Souta, Kashiwa-shi, Chiba 277-8557 (JP); YAMASAKI, Yuzuru, Kashiwa-shi, Chiba 277-8557 (JP)
(74) Representative: Vossius & Partner Patentanwälte Rechtsanwälte mbB
(86) International application number: PCT/JP2024/046052
(87) International publication number: WO 2025/143074

(57) **Abstract**

Provided is a ferrite powder containing: as a main component compound, a magnetoplumbite-type hexagonal ferrite having a composition represented by a formula of Sr(FeₓAl_{y}Zr_{z})₁₂O_{19+δ} (where x, y, z, and δ satisfy 0.400 ≤ x <1.000, 0.030 ≤ y ≤ 0.350, 0.001 ≤ z ≤ 0.040, 0.750 ≤ x + y + z <1.000, and -5.00 ≤ δ ≤ -0.200), in which the ferrite powder has a volume resistivity of 1.0 × 10⁹ Ω·cm or less, a ferrite resin composite material containing the ferrite powder, a ferrite resin composite, and an electromagnetic wave absorber.

## Description

### TECHNICAL FIELD

The present invention relates to a magnetoplumbite-type hexagonal ferrite powder, a ferrite resin composite material, a ferrite resin composite, and an electromagnetic wave absorber.

### BACKGROUND ART

With development of information communication technology in recent years, various communication devices have been developed and used. A frequency band to be used is also shifted from a microwave band to a high-frequency band including a millimeter wave. For example, systems using electromagnetic waves (radio waves) in a millimeter wave bandwidth, such as a high-speed wireless LAN (65 GHz) and a collision prevention radar (76.5 GHz), are introduced. The millimeter wave is an electromagnetic wave having a frequency band of 30 GHz or more and 300 GHz or less, and has an advantage of being suitable for high-speed large-capacity communication.

On the other hand, unintended unrequired electromagnetic waves are also generated from communication devices. Unrequired electromagnetic waves may cause electromagnetic interference (EMI). Specifically, a malfunction or a failure of another device may be caused, or a human body may be adversely affected. Therefore, importance of electromagnetic compatibility (EMC) measures for improving an electromagnetic environment is strongly recognized. Then, as a specific measure against EMC, a method of absorbing the unrequired electromagnetic waves using an electromagnetic wave absorber and preventing an influence thereof is used.

As the electromagnetic wave absorber, a magnetic material, a dielectric material, and/or a conductive material is used. Magnetic resonance occurs in the magnetic material in response to electromagnetic waves of a specific frequency. At this time, the magnetic material exhibits a large magnetic loss, and most of electromagnetic wave energy is absorbed by the material and converted into thermal energy. Therefore, the electromagnetic wave can be absorbed by using the magnetic loss. In the dielectric material, a dielectric loss occurs due to a deviation between a phase of the electromagnetic wave and a phase of an dielectric polarization, and the electromagnetic wave can be absorbed by using the dielectric loss.

Ferrite has been proposed as an electromagnetic wave absorber magnetic material, and among them, sintered bodies, such as spinel-type ferrite, and magnetic composites are frequently used. As a document disclosing such a technique, Patent Literature 1 proposes a radio wave absorber including a spinel main phase containing Fe₂O₃ of 40.0 mol% to 49.9 mol%, ZnO of 4.0 mol% to 26.5 mol%, and a balance of MnO, and a sub-phase containing CaO as a main component, in which a mass ratio of the spinel main phase is 50 mass% to 99 mass% with respect to a total mass of the spinel main phase and the sub-phase (claim 1 of Patent Literature 1).

### PRIOR ART DOCUMENT

### PATENT LITERATURE

Patent Literature 1: JP2004-247603A

### SUMMARY OF INVENTION

### OBJECT TO BE ACHIEVED BY THE INVENTION

As described above, although an electromagnetic wave absorber containing a ferrite has been conventionally proposed, it is less likely to obtain an excellent electromagnetic wave absorption performance in a high frequency bandwidth, such as a millimeter wave band, in the conventional art.

That is, according to a theory known as Snoek's limit, magnetic properties of the magnetic material, such as ferrite, are restricted in the high frequency bandwidth. In particular, it is less likely to obtain high magnetic permeability in the high frequency bandwidth with a material having small magnetic anisotropy, such as the spinel-type ferrite. Therefore, in the conventional art, there is a limit in obtaining an excellent electromagnetic wave absorption performance in the high frequency bandwidth.

The present inventors have conducted intensive studies in view of such problems. As a result, it was found that a magnetoplumbite-type hexagonal ferrite powder having a predetermined composition and indicating a specific electrical resistance has not only high magnetic properties but also dielectric properties in the millimeter wave bandwidth. Then, it was found that by using this ferrite powder, an electromagnetic wave absorber indicating an excellent electromagnetic wave absorption performance in the millimeter wave bandwidth can be obtained even with a thickness equivalent to that in the conventional art.

The present invention has been completed based on such findings, and an object thereof is to provide a magnetoplumbite-type hexagonal ferrite powder from which an electromagnetic wave absorber indicating an excellent electromagnetic wave absorption performance in a millimeter wave bandwidth despite having a thickness equivalent to that in the conventional art can be obtained. Another object thereof is to provide a ferrite resin composite material containing the ferrite powder, a ferrite resin composite, and an electromagnetic wave absorber.

### MEANS FOR ACHIEVING THE OBJECT

The present invention encompasses the following aspects (1) to (7). In the present description, the expression "to" includes numerical values at both ends thereof. That is, "X to Y" has the same meaning as "X or more and Y or less". In the present specification, any combination of preferable aspects can be adopted as long as technical matching can be achieved. For example, one and the other of preferable numerical ranges can be freely combined.
(1) A ferrite powder containing:
   as a main component compound, a magnetoplumbite-type hexagonal ferrite having a composition represented by a formula of Sr(FeₓAl_{y}Zr_{z})₁₂O_{19+δ} (where x, y, z, and δ satisfy 0.400 ≤ x <1.000, 0.030 ≤ y ≤ 0.350, 0.001 ≤ z ≤ 0.040, 0.750 ≤ x + y + z <1.000, and -5.00 ≤ δ ≤ -0.200), in which
   the ferrite powder has a volume resistivity of 1.0 × 10⁹ Ω·cm or less.
(2) The ferrite powder according to (1), in which the ferrite powder has an average particle diameter of 3 µm or more and 35 µm or less.
(3) The ferrite powder according to (1) or (2), in which
   a content of each of strontium (Sr), aluminum (Al), and zirconium (Zr) is as follows:
   Sr is 8.0 mass% or more and 12 mass% or less,
   Al is 1.0 mass% or more and 15 mass% or less, and
   Zr is 0.10 mass% or more and 4.5 mass% or less.
(4) The ferrite powder according to any one of (1) to (3), in which a content of divalent iron ions (Fe²⁺) is 0.05 mass% or more and 4.0 mass% or less.
(5) A ferrite resin composite material including:
   the ferrite powder according to any one of (1) to (4); and
   a resin.
(6) A ferrite resin composite that is a molded article of the ferrite resin composite material according to (5).
(7) An electromagnetic wave absorber including: the ferrite resin composite according to (6).

### EFFECTS OF INVENTION

According to the present invention, a magnetoplumbite-type hexagonal ferrite powder from which an electromagnetic wave absorber indicating an excellent electromagnetic wave absorption performance in a millimeter wave bandwidth despite having a thickness equivalent to that in the conventional art is provided. A ferrite resin composite material containing the ferrite powder, a ferrite resin composite, and an electromagnetic wave absorber are provided.

### EMBODIMENTS FOR CARRYING OUT THE INVENTION

A specific embodiment according to the present invention (hereinafter referred to as "the present embodiment") will be described. The present invention is not limited to the following embodiment, and various modifications can be made without departing from the gist of the present invention.

In the present invention, a combination of two or more preferable aspects is a more preferable aspect.

### <<1. Ferrite Powder>>

A ferrite powder according to the present embodiment contains, as a main component compound, a magnetoplumbite-type hexagonal ferrite (hereinafter, may be referred to as an "M-type ferrite") having a composition represented by the formula Sr(FeₓAl_{y}Zr_{z})₁₂O_{19+δ}, (where x, y, z, and δ satisfy 0.400 ≤ x <1.000, 0.030 ≤ y ≤ 0.350, 0.001 ≤ z ≤ 0.040, 0.750 ≤ x + y + z <1.000, and -5.00 ≤ δ ≤ -0.200). A volume resistivity of the ferrite powder is 1.0 × 10⁹ Ω cm or less. Such a ferrite powder can improve an electromagnetic wave absorption performance using not only magnetic loss but also dielectric loss. Then, it is suitable for use in electromagnetic wave absorption (shield) in a high frequency bandwidth, particularly in a millimeter wave bandwidth.

The M-type ferrite is an oxide having a composition represented by a general formula of MFe₁₂O₁₉ (where M is a metal element, such as strontium (Sr) or barium (Ba)) and having a hexagonal crystal structure (space group: P63/mmc). M (Sr, Ba, or the like) is usually contained in the M-type ferrite in a form of divalent ions (M²⁺). Iron (Fe) is usually contained in a form of trivalent ions (Fe³⁺). Iron ions (Fe³⁺) may be substituted with other transition metal ions having a size close to that of iron ions.

By using the M-type ferrite as the main component compound, it is possible to impart an excellent electromagnetic wave absorption performance in a high frequency bandwidth to the ferrite powder. That is, a ferromagnetic material exhibits a high magnetic loss at a specific frequency (a resonance frequency) by ferromagnetic resonance (FMR). It is known that a resonance frequency (an FMR frequency) indicating the magnetic loss is proportional to a magnitude of the magnetic anisotropy (a magnetic anisotropy constant) of the material. In this regard, the M-type ferrite is a ferromagnetic material. Unlike a spinel-type ferrite, the M-type ferrite has uniaxial magnetic anisotropy and large magnetic anisotropy. Therefore, by using such an M-type ferrite as a main component, a ferrite powder having a high FMR frequency and an excellent electromagnetic wave absorption performance (an EMI shielding performance) in the high frequency bandwidth can be obtained. Specifically, the FMR can be induced in a high frequency bandwidth of 45 GHz or more.

In the present description, the main component means a component having the largest mass in the ferrite powder. That is, the ferrite powder contains the M-type ferrite by a content of 50 mass% or more and 100 mass% or less.

The ferrite powder may contain components other than the M-type ferrite. Examples of other components include raw material components (Fe₂O₃, Al₂O₃, ZrO₂, and the like) and intermediate products used in production of the ferrite powder. However, from a viewpoint of taking advantage of excellent properties of the M-type ferrite, the content of M-type ferrite is preferably high. The content of M-type ferrite is preferably 70 mass% or more and 100 mass% or less, more preferably 80 mass% or more and 100 mass% or less, and still more preferably 90 mass% or more and 100 mass% or less. A content of other components, for example, iron oxide (Fe₂O₃), is preferably 0 mass% or more and 30 mass% or less, more preferably 0 mass% or more and 20 mass% or less, and still more preferably 0 mass% or more and 10 mass% or less.

By setting the contents of the M-type ferrite and other components (Fe₂O₃, and the like) within the above-described ranges, an absorption performance suitable for desired applications can be easily obtained. On the other hand, when the content of the M-type ferrite is too small, the magnetic properties (saturation magnetization and coercive force) deteriorate, and it is less likely to obtain excellent absorption performance. The contents of the M-type ferrite and other components can be determined by analyzing the ferrite powder by an X-ray diffraction method and subjecting an obtained X-ray diffraction pattern to Rietveld analysis. Specifically, the contents may be obtained by a method in examples to be described later or a method based thereon.

The ferrite powder according to the present embodiment contains aluminum (Al) in the M-type ferrite. Accordingly, the resonance frequency (the FMR frequency) indicating the magnetic loss increases, and as a result, the electromagnetic wave absorption performance in a desired frequency band can be improved. Although not to be construed as being limited, the following mechanism can be cited as a reason therefor.

As described above, by using the M-type ferrite, the ferrite powder having an electromagnetic wave absorption performance (the EMI shielding performance) in the high frequency bandwidth can be obtained. However, since the ferromagnetic resonance (FMR) occurs in a specific frequency band, it is less likely to obtain broadband or multiband absorption performance only with a pure M-type ferrite.

In contrast, aluminum (Al) is usually stable in a trivalent ion (Al³⁺) state in an oxide. An aluminum ion (Al³⁺) has a size (an ionic radius) close to that of the trivalent iron ion (Fe³⁺). Therefore, it is considered that Al becomes Al³⁺ in the M-type ferrite and substitutes Fe³⁺. It has been reported that when Fe³⁺ in the M-type ferrite is substituted with Al³⁺, the magnitude of magnetic anisotropy (the magnetic anisotropy constant) changes. Since the FMR frequency is proportional to the magnitude of the magnetic anisotropy of the material, the FMR frequency can be controlled by Al substitution.

The ferrite powder according to the present embodiment also contains zirconium (Zr). Accordingly, the electromagnetic wave absorption performance can be further improved. Although not to be construed as being limited, the following mechanism can be cited as a reason therefor.

Zirconium (Zr) is usually stable in a tetravalent ion (Zr⁴⁺) state in an oxide. A zirconium ion (Zr⁴⁺) has a size (the ionic radius) close to that of the trivalent iron ions (Fe³⁺). Therefore, it is considered that Zr becomes Zr⁴⁺ in the M-type ferrite and substitutes Fe³⁺. However, Zr⁴⁺ and Fe³⁺ have different valences. It is considered that the substitution of Zr⁴⁺ causes a part of Fe³⁺ to change into divalent iron ions (Fe²⁺) or create oxygen vacancies (VO). This is because generation of Fe²⁺ or oxygen vacancies satisfies a charge neutrality condition, thereby stabilizing a crystal structure.

In contrast, when the divalent iron ion (Fe²⁺) or the oxygen vacancies (VO) are generated, charge bias occurs in the crystal, which induces electric dipole and dielectric polarization. It is considered that the induction of the dielectric polarization increases the dielectric properties and a resulting loss (the dielectric loss), and the dielectric loss can be used for electromagnetic wave absorption. Indeed, the present inventors have confirmed that a relative permittivity (εr) increases and an electrical resistance (the volume resistivity) decreases by incorporating zirconium (Zr) into the ferrite powder. These all support the generation of Fe²⁺ and oxygen vacancies.

An Fe amount (x) in a composition formula (Sr(FeₓAl_{y}Zr_{z})₁₂O_{19+δ}) of the M-type ferrite as the main component compound of the ferrite powder is 0.400 or more and less than 1.000 (0.400 ≤ x <1.000). When x is less than 0.400, the M-type ferrite has an Fe-deficient composition. The magnetic properties (the saturation magnetization and coercive force) are deteriorated, and accordingly, the electromagnetic wave absorption performance may be deteriorated. In contrast, when x is 1.000 or more, an Fe excess composition is obtained. Solid solution of Al and Zr in the M-type ferrite is inhibited, which may make it less likely to obtain effects of adding Al and Zr. x is preferably 0.500 or more and 0.900 or less (0.500 ≤ x ≤ 0.900), and more preferably 0.600 or more and 0.800 or less (0.600 ≤ x ≤ 0.800).

As a preferable aspect, the Fe amount (x) is preferably 0.400 or more and 0.900 or less, and more preferably 0.400 or more and 0.800 or less.

As a preferable aspect, the Fe amount (x) is preferably 0.500 or more and less than 1.000, more preferably 0.500 or more and 0.900 or less, and still more preferably 0.500% or more and 0.800 or less.

As a preferable aspect, the Fe amount (x) is preferably 0.600 or more and less than 1.000, more preferably 0.600 or more and 0.900 or less, and still more preferably 0.600 or more and 0.800 or less.

An Al amount (y) in the composition formula of the M-type ferrite is 0.030 or more and 0.350 or less (0.030 ≤ y ≤ 0.350). When y is less than 0.030, an Al-deficient composition is obtained. The resonance frequency changes, which is inappropriate for applying the ferrite powder to a desired application. In contrast, when y exceeds 0.350, an Al excess composition is obtained. A content of an Al-based oxide (SrAl₂O₄, Al₂O₃, or the like) that is a non-ferromagnetic component increases, and the electromagnetic wave absorption performance may be deteriorated. y is preferably 0.030 or more and 0.300 or less (0.030 ≤ y ≤ 0.300), and more preferably 0.030 or more and 0.250 or less (0.030 ≤ y ≤ 0.250).

A Zr amount (z) in the composition formula of the M-type ferrite is 0.001 or more and 0.040 or less (0.001 ≤ z ≤ 0.040). When z is less than 0.001, a Zr-deficient composition is obtained. An effect of improving the dielectric properties by adding Zr may not be obtained, and the electromagnetic wave absorption performance may be deteriorated. In contrast, when z exceeds 0.040, a Zr excess composition is obtained. Since an amount of oxygen vacancies is insufficient, the electromagnetic wave absorption performance may be deteriorated. z is preferably 0.020 or more and 0.040 or less (0.020 ≤ z ≤ 0.040), and more preferably 0.030 or more and 0.040 or less (0.030 ≤ z ≤ 0.040).

A total (x + y + z) of the Fe amount, the Al amount, and Zr amount in the composition formula of the M-type ferrite is 0.750 or more and less than 1.000 (0.750 ≤ x + y + z <1.000). When x + y + z is less than 0.750, a content of Fe site ions in the M-type ferrite decreases. The magnetic properties (the saturation magnetization and coercive force) are deteriorated, and accordingly, the electromagnetic wave absorption performance may be deteriorated. Since an excess composition of Sr, Al, and Zr is obtained, a compound, such as SrAl₂O₄, Al₂O₃ and/or ZrO that is not ferritized during sintering may remain in the ferrite powder as a heterogeneous phase. When these heterogeneous phases remain, the magnetic properties may be deteriorated. In contrast, when x + y + z is 1.000 or more, solid solution of Al and Zr in the M-type ferrite is inhibited, and it may be less likely to obtain the effects of adding Al and Zr. Since the Fe excess composition is obtained, Fe₃O₄ may remain in the ferrite powder during sintering. Fe₃O₄ is a ferrimagnetic material, and when Fe₃O₄ is generated, it is less likely to selectively absorb electromagnetic waves in a desired frequency range (around 50 GHz to 75 GHz). x + y + z is preferably 0.800 or more and less than 1.000 (0.800 ≤ x + y + z <1.000), and more preferably 0.850 or more and less than 1.000 (0.850 ≤ x + y + z <1.000).

An absolute value of δ in an oxygen (O) amount (19 + δ) in the composition formula of the M-type ferrite means an amount of oxygen vacancies (deficiencies). δ is -5.00 or more and -0.200 or less (-5.00 ≤ δ ≤ -0.200). As described above, a pure M-type ferrite containing no substituent element has a composition represented by the general formula of MFe₁₂O₁₉. Therefore, the oxygen (O) amount is 19. In contrast, since the ferrite powder according to the present embodiment contains substituent elements (Zr and the like), the ferrite powder contains the divalent iron ions (Fe²⁺) and the oxygen vacancies (VO). Since an oxygen (O)-deficient composition is obtained as compared with the pure M-type ferrite, δ takes a negative value. By setting δ within a desired range, oxygen vacancies having an effect of improving electromagnetic wave absorption performance are generated in a desired amount. When δ is less than -5.00 (δ < -5.00), a lattice defect of the M-type ferrite is excessive, and contribution to a dielectric constant is insufficient. Therefore, the electromagnetic wave absorption performance is deteriorated. Even when δ exceeds -0.200 (-0.200 < δ), contribution to the dielectric constant is small, and the electromagnetic wave absorption performance is deteriorated. δ is preferably -4.00 or more and -1.00 or less (-4.00 ≤ δ ≤ -1.00), and more preferably -3.00 or more and -2.00 or less (-3.00 ≤ δ ≤ -2.00).

As a preferable aspect, δ in the oxygen (O) amount (19 + δ) is preferably -5.00 or more and -1.00 or less, and more preferably -5.00 or more and -2.00 or less.

As a preferable aspect, δ in the oxygen (O) amount (19 + δ) is preferably -4.00 or more and -0.200 or less, more preferably -4.00 or more and -1.00 or less, and still more preferably -4.00 or more and -2.00 or less.

As a preferable aspect, δ in the oxygen (O) amount (19 + δ) is preferably -3.00 or more and -0.200 or less, more preferably -3.00 or more and -1.00 or less, and still more preferably -3.00 or more and -2.00 or less.

x, y, z, x + y + z, and δ are preferably 0.500 ≤ x ≤ 0.900, 0.030 ≤ y ≤ 0.300, 0.020 ≤ z ≤ 0.040, 0.800 ≤ x + y + z <1.000, and -4.00 ≤ δ ≤ -1.00, and more preferably 0.600 ≤ x ≤ 0.800, 0.030 ≤ y ≤ 0.250, 0.030 ≤ z ≤ 0.040, 0.850 ≤ x + y + z <1.000, and -3.00 ≤ δ ≤ -2.00.

The ferrite powder according to the present embodiment has a volume resistivity of 1.0 × 10⁹ Ω·cm or less. By maintaining the volume resistivity (the electrical resistance) at a low level, it is possible to further improve the electromagnetic wave absorption performance in the high frequency bandwidth. That is, as described above, the ferrite powder according to the present embodiment has oxygen vacancies. It is considered that the electrical resistance (the volume resistivity) decreases due to the presence of the oxygen vacancies. The presence of oxygen vacancies causes dielectric loss, which is considered to contribute to improvement of the electromagnetic wave absorption performance. When the electrical resistance (volume resistivity) is excessively high, excellent absorption performance due to oxygen vacancies cannot be obtained. From the viewpoint of improving the electromagnetic wave absorption performance, the volume resistivity is desirably low. Specifically, the volume resistivity is preferably 1.0 × 10⁸ Ω·cm or less, and more preferably 1.0 × 10⁷ Ω·cm or less. Specifically, the volume resistivity may be measured by a method in examples to be described later or a method based thereon.

When the volume resistivity is too low, it is considered that transmission properties in the electromagnetic wave absorption performance deteriorate, and thus the volume resistivity is preferably 1.0 × 10⁶ Ω·cm or more.

An average particle diameter of the ferrite powder is preferably 3 µm or more and 35 µm or less, more preferably 3 µm or more and 25 µm or less, and still more preferably 3 µm or more and 15 µm or less. In many cases, a composite material is prepared by mixing the ferrite powder as a filler with a resin, and the composite material is molded to obtain a composite (an electromagnetic wave absorber or the like). When the average particle diameter is within the above-described range, fluidity and metering/handling properties of the ferrite powder and the composite material are improved. Therefore, a filler filling rate of the composite material is improved, and a composite (an electromagnetic wave absorber or the like) having excellent mechanical strength can be obtained.

In contrast, when the average particle diameter of the ferrite powder is too small, the fluidity of the ferrite powder and the composite material decreases, and particles (ferrite particles) constituting the ferrite powder are likely to aggregate. Therefore, it is less likely to obtain a composite having a high filler filling rate. When an average particle is too large, voids between the ferrite particles are large. Therefore, it is also less likely to obtain a composite having a high filler filling rate. The average particle diameter may be measured using a particle size analyzer. Specifically, the measurement may be performed by a method in examples to be described later or a method based thereon.

Contents of strontium (Sr), aluminum (Al), and zirconium (Zr) in the ferrite powder are preferably Sr of 8.0 mass% or more and 12 mass% or less, Al of 1.0 mass% or more and 15 mass% or less, and Zr of 0.10 mass% or more and 4.5 mass% or less. Accordingly, it is possible to impart more excellent electromagnetic wave absorption performance to the ferrite powder. Specifically, when the Sr content is within the above-described range, a ferrite powder indicating electromagnetic wave absorption performance suitable for a desired application can be obtained. When the Al content is within the above-described range, the resonance frequency can be optimized. For example, an electromagnetic wave absorber that functions in a 60 GHz band (60 GHz to 65 GHz) can be obtained. When the Zr content is within the above-described range, the oxygen vacancies are induced to further improve the absorption performance.

In contrast, when the Sr amount is excessively small, the magnetic properties (the saturation magnetization and the coercive force) of the ferrite powder are deteriorated, and thus the electromagnetic wave absorption performance may be deteriorated. In contrast, when the Sr amount is excessively large, generation of an Sr-based oxide (Sr-Fe oxides, SrO, and the like) that is a non-ferromagnetic component progresses, which may lead to a decrease in absorption performance. When the Al amount is excessively small, the effect of increasing the resonance frequency (the FMR frequency) based on Al substitution is insufficient. Therefore, the FMR frequency shifts to a low-frequency side, which may be inappropriate depending on the application. When the Al amount is excessively large, the FMR frequency shifts to a high-frequency side, which may also be inappropriate depending on the application. Generation of the Al-based oxide (SrAl₂O₄, Al₂O₃ or the like), which is a non-ferromagnetic component, progresses, which may lead to a decrease in absorption performance. When the Zr amount is excessively small, oxygen vacancies that contribute to dielectric loss development are reduced, and thus the absorption performance may be deteriorated. When the Zr amount is excessively large, generation of a Zr-based component (a Zr-Fe oxide and ZrO) that is a non-ferromagnetic component progresses, which may lead to a decrease in absorption performance.

From the viewpoint of further improving the electromagnetic wave absorption performance, the contents of strontium (Sr), aluminum (Al), and zirconium (Zr) are more preferably Sr of 8.0 mass% or more and 11 mass% or less, Al of 1.0 mass% or more and 11 mass% or less, and Zr of 2.0 mass% or more and 4.5 mass% or less, and still more preferably Sr of 8.0 mass% or more and 10 mass% or less, Al of 1.0 mass% or more and 7.0 mass% or less, and Zr of 3.0 mass% or more and 4.5 mass% or less. The contents of Sr, Al, and Zr can be determined by chemical analysis of the ferrite powder. Specifically, the analysis may be performed by a method in examples to be described later or a method based thereon.

A content of divalent iron ions (Fe²⁺) in the ferrite powder is preferably 0.05 mass% or more and 4.0 mass% or less, more preferably 2.0 mass% or more and 4.0 mass% or less, and still more preferably 3.0 mass% or more and 4.0 mass% or less. When the Fe²⁺ amount is within the above-described range, the effect of improving the electromagnetic wave absorption performance using the dielectric properties (the dielectric loss) can be remarkably achieved. In contrast, when the Fe²⁺ amount is excessively small, there is a limit in improving the dielectric properties. When the Fe²⁺ amount is excessively large, excessive oxidation of the ferrite powder may proceed, and the magnetic properties (the saturation magnetization and the coercive force) may deteriorate. Fe²⁺ in the ferrite particles is generated due to Zr in the particles. Therefore, the presence or absence of Zr can be confirmed by evaluating the Fe²⁺ amount. The Fe²⁺ amount can be determined by oxidation-reduction titration. Specifically, the measurement may be performed by a method of Examples described later or a method based thereon.

The contents of Sr, Al, Zr, and Fe²⁺ are preferably Sr of 8.0 mass% or more and 11 mass% or less, Al of 1.0 mass% or more and 11 mass% or less, Zr of 2.0 mass% or more and 4.5 mass% or less, and Fe²⁺ of 2.0 mass% or more and 4.0 mass% or less, and still more preferably Sr of 8.0 mass% or more and 10 mass% or less, Al of 1.0 mass% or more and 7.0 mass% or less, Zr of 3.0 mass% or more and 4.5 mass% or less, and Fe²⁺ of 3.0 mass% or more and 4.0 mass% or less.

Regarding the dielectric properties of the ferrite powder, the relative permittivity (εr) is preferably 10 or more, more preferably 12 or more, and still more preferably 14 or more. When the relative permittivity is sufficiently high, intrusion of electromagnetic waves into the electromagnetic wave absorber containing the ferrite powder and electromagnetic wave absorption using the dielectric properties (the dielectric loss) are more effectively performed. Therefore, the absorption performance can be further improved. In contrast, when the relative permittivity is excessively low, intrusion of the electromagnetic wave may not be performed smoothly. The relative permittivity (εr) is measured by a free-space method in a frequency band of 50 GHz to 75 GHz. Specifically, the measurement may be performed by a method in examples to be described later or a method based thereon.

When the relative permittivity is too high, it is considered that the transmission properties in the electromagnetic wave absorption performance deteriorate, and thus, the relative permittivity is preferably 30 or less.

Regarding the magnetic properties of the ferrite powder, the saturation magnetization (Ms) is preferably 10 emu/g or more and 50 emu/g or less, more preferably 10 emu/g or more and 40 emu/g or less, and still more preferably 10 emu/g or more and 30 emu/g or less. Residual magnetization (Mr) is preferably 15 emu/g or more and 35 emu/g or less, more preferably 15 emu/g or more and 30 emu/g or less, and still more preferably 15 emu/g or more and 25 emu/g or less. The coercive force (Hc) is preferably 6000 Oe or less, more preferably 5000 Oe or less, and still more preferably 4000 Oe or less. By setting the Ms, the Mr, and the Hc within the above-described ranges, magnetization rotation in a high frequency bandwidth is smoothly performed, and thus a real part of magnetic permeability (µ') increases. Therefore, it is possible to obtain an electromagnetic wave absorption performance suitable for a desired application. In contrast, when Ms is excessively large and Hc is excessively small, the FMR frequency excessively shifts to the low-frequency side, which may be less likely to obtain an excellent absorption performance in the desired frequency band. When Ms is excessively small and Hc is excessively large, the FMR frequency may excessively shift to the high-frequency side.

When the coercive force is too low, it is considered that the frequency in the electromagnetic wave absorption performance decreases, and thus the coercive force is preferably 1000 Oe.

The magnetic properties may be measured by a method in examples to be described later or a method based thereon.

### <<2. Method for Producing Ferrite Powder>>

A method for producing the ferrite powder according to the present embodiment is not limited as long as the above-described requirements are satisfied. However, preferably, the following steps are included: a step of mixing a strontium (Sr) source, an iron (Fe) source, an aluminum (Al) source, a zirconium (Zr) source, water, and optionally a binder, a dispersant, a defoaming agent, and/or a pH adjuster to prepare a slurry (a raw material mixing step), a step of spraying and granulating the obtained slurry to prepare a granulated product (a granulating step); and a step of sintering the obtained granulated product to prepare a sintered product (a sintering step). Optionally, a step of subjecting the obtained sintered product to a post-treatment (a post-treatment step) may be provided. Each step will be described in detail below.

### <Raw Material Mixing Step>

In the mixing step, the strontium (Sr) source, the iron (Fe) source, the aluminum (Al) source, the zirconium (Zr) source, water, and optionally the binder, the dispersant, the defoaming agent, and/or the pH adjuster are prepared as raw materials, and these raw materials are mixed to prepare the slurry. As the Sr source, the Fe source, the Al source, and the Zr source, known ferrite raw materials, such as oxides, carbonates, and hydroxides, may be used. Preferably, strontium carbonate (SrCO₃), iron oxide (Fe₂O₃), aluminum oxide (Al₂O₃), and zirconium oxide (ZrO₂) are used. These raw materials are inexpensive. The raw materials are stable under normal temperature and normal humidity, and are excellent in handleability.

Optionally, additives, such as a binder, a dispersant, a defoaming agent, and a pH adjuster, may be added. The binder is added for a purpose of improving a strength of the granulated product obtained after spray granulation. As the binder, a resin compound, such as polyvinyl alcohol (PVA) and/or polyvinyl pyrrolidone (PVP), may be used.

The raw materials (the Sr source, the Fe source, the Al source, the Zr source, and water,) may be mixed by a known method. For example, the raw materials may be mixed using a mixing and grinding machine, such as a wet bead mill, to form a slurry. A solid content concentration of the obtained slurry is preferably 30 mass% or more and 75 mass% or less, more preferably 45 mass% or more and 65 mass% or less, and still more preferably 50 mass% or more and 60 mass% or less.

As a preferable aspect, the solid content concentration of the slurry is preferably 30 mass% or more and 65 mass% or less, and more preferably 30 mass% or more and 60 mass% or less.

As a preferable aspect, the solid content concentration of the slurry is preferably 45 mass% or more and 75 mass% or less, more preferably 45 mass% or more and 65 mass% or less, and still more preferably 45 mass% or more and 60 mass% or less.

As a preferable aspect, the solid content concentration of the slurry is preferably 50 mass% or more and 75 mass% or less, more preferably 50 mass% or more and 65 mass% or less, and still more preferably 50 mass% or more and 60 mass% or less.

### <Granulating Step>

In the granulating step, the obtained slurry is subjected to spray granulation to produce the granulated product. The spray granulation may be performed using a spray dryer. The granulation may be performed under known conditions. Examples of conditions include a slurry discharge amount of 200 g/min or more and 500 g/min or less, an atomizer disk rotation speed of 1000 rpm or more and 12000 rpm or less, and a drying temperature of 100°C or higher and 500°C or lower. The average particle diameter of the granulated product formed in the granulating step is preferably 20 µm or more and 120 µm or less.

In the granulating step, the obtained granulated product may be subjected to a binder removal treatment. In the binder removal treatment, the granulated product is heated to decompose and remove organic components, such as the binder, thereby obtaining a degreased product. The binder removal treatment may be performed using a known heating furnace. The heating may be performed under conditions under which the organic components are removed, for example, at a condition having a temperature of 650°C or higher and 1050°C or lower for 0.5 hours or longer and 12 hours or shorter. As the binder, a resin binder, such as polyvinyl alcohol (PVA), polyvinyl pyrrolidone, and/or an acrylic resin binder can be used, and an addition amount thereof is 0.05 mass% or more and 1.0 mass% or less in terms of solid content with respect to a raw material mixture.

### <Sintering Step>

In the sintering step, the obtained granulated product or degreased product is sintered to obtain the sintered product. A sintering temperature is preferably 1100°C or higher and 1300°C or lower, more preferably 1200°C or higher and 1300°C or lower, and still more preferably 1220°C or higher and 1260°C or lower. When the sintering temperature is within the above-described ranges, a ferrite powder indicating electromagnetic wave absorption performance suitable for a desired application can be obtained. In contrast, when the sintering temperature is too low, the FMR frequency may excessively shift to the low-frequency side, and the absorption performance may be deteriorated. When the sintering temperature is too high, the FMR frequency may excessively shift to the high-frequency side, and the absorption performance may be deteriorated.

In a preferable aspect, the sintering temperature is preferably 1100°C or higher and 1260°C or lower.

In a preferable aspect, the sintering temperature is preferably 1200°C or higher and 1300°C or lower, and more preferably 1200°C or higher and 1260°C or lower.

In a preferable aspect, the sintering temperature is preferably 1220°C or higher and 1300°C or lower, and more preferably 1220°C or higher and 1260°C or lower.

The sintering may be held for 3 hours or longer and 6 hours or shorter.

The sintering can be performed in a nitrogen atmosphere. An oxygen (O₂) concentration in the atmosphere is preferably 10 volume% or less, more preferably 5.0 volume% or less, and still more preferably 1.0 volume% or less. By reducing the O₂ concentration in the atmosphere, the formation of Fe²⁺ and the oxygen vacancies in the obtained ferrite powder is promoted. Therefore, the effect of dielectric properties (the dielectric loss) due to the oxygen vacancies can be sufficiently used. In contrast, when the O₂ concentration is too high, Fe²⁺ and the oxygen vacancies may be reduced, and the absorption performance may be deteriorated.

### <Post-Treatment Step>

Optionally, the sintered product may be subjected to a post-treatment. Examples of the post-treatment include a pulverization treatment, a heat treatment, and a classification treatment. The post-treatment may be performed alone or may be performed in combination. In this way, the ferrite powder according to the present embodiment can be obtained.

### <<3. Ferrite Resin Composite Material>>

A ferrite resin composite material (hereinafter may be referred to as a "composite material") according to the present embodiment includes the above-described ferrite powder and resin. The composite material is a precursor material of a ferrite resin composite, which is a constituent member of the electromagnetic wave absorber. That is, the composite material is molded to prepare a composite.

Examples of resin constituting the composite material include an epoxy resin, a urethane resin, an acrylic resin, a silicone resin, a polyamide resin, a polyimide resin, a polyamideimide resin, a fluororesin, and a combination thereof. The silicone resin may be a modified silicone resin modified with acrylic, urethane, epoxy, and/or fluorine.

The composite material may contain components other than the ferrite powder and the resin. Examples of such components include a solvent, a filler (an organic filler and an inorganic filler), a plasticizer, an antioxidant, a dispersant, a colorant such as a pigment, and/or thermally conductive particles.

A ratio of the ferrite powder to a total solid content in the composite material is preferably 50 mass% or more and 95 mass% or less, and more preferably 80 mass% or more and 95 mass% or less. A ratio of the resin to the total solid content in the composite material is preferably 5 mass% or more and 50 mass% or less, and more preferably 5 mass% or more and 20 mass% or less. When the ratio of the ferrite powder or the resin is set within the above-described range, dispersion stability of the ferrite powder and storage stability and moldability of the composite material are excellent, and properties of the composite obtained by molding the composite material, such as mechanical strength and magnetic properties, are more excellent.

### <<4. Ferrite Resin Composite>>

The ferrite resin composite (hereinafter may be referred to as a "composite") according to the present embodiment is a molded article of the above-described ferrite resin composite material. That is, the composite material is molded to prepare the composite. A molding method is not particularly limited, and examples thereof include compression molding, extrusion molding, injection molding, blow molding, or calender molding. A method of forming a coating film of the composite material on a substrate may be used.

The filler filling rate of the composite is preferably 70 volume% or more, more preferably 80 volume% or more, and still more preferably 90 volume% or more. The filler filling rate is a standard of a ratio of ferrite particles (particles constituting the ferrite powder) in the composite. By setting the filler filling rate within the above-described range, the dispersion stability of the ferrite particles and the storage stability and the moldability of the composite are excellent. In contrast, when the filler filling rate is excessively low, a strength of the composite may decrease.

When the filler filling rate is excessively high, it is considered that a molded article density is reduced, and thus the filler filling rate is preferably 99 volume% or less.

The filler filling rate can be determined as a ratio of the ferrite particles in a cross-sectional SEM image obtained by SEM observation of a cross section of the composite. Specifically, the measurement may be performed by a method in examples to be described later or a method based thereon. However, a magnification at the time of SEM observation may be selected according to a particle diameter of the ferrite powder and a thickness of the composite.

A bending strength of the composite is preferably 1000 MPa or more, more preferably 2000 MPa or more, and still more preferably 3000 MPa or more. Accordingly, it is possible to obtain a composite having an excellent mechanical strength. In contrast, when the bending strength is excessively low, defects such as chipping and cracking of the composite are likely to occur. The bending strength is a biaxial bending strength measured in a biaxial bending test. Specifically, the measurement may be performed by a method in examples to be described later or a method based thereon.

### <<5. Electromagnetic Wave Absorber>>

An electromagnetic wave absorber according to the present embodiment includes the above-described ferrite resin composite. The electromagnetic wave absorber may be implemented by only the composite, or may be provided with other members. For example, an impedance matching layer or a surface protective layer may be provided on a surface of the composite. A reflective member may be provided on a back surface. Examples of the impedance matching layer include a layer in which a magnetic powder or a dielectric powder is dispersed in a resin. Examples of the surface protective layer include a layer formed of a resin or glass. Examples of the reflective member include a film-shaped, foil-shaped, or net-shaped metal member.

The electromagnetic wave absorber desirably has a peak in frequency properties of reflection attenuation. A peak frequency of the reflection attenuation is preferably 50 GHz or more and 75 GHz or less, more preferably 55 GHz or more and 70 GHz or less, and still more preferably 60 GHz or more and 65 GHz or less.

As a preferable aspect, the peak is preferably 50 GHz or more and 70 GHz or less, and more preferably 50 GHz or more and 65 GHz or less.

As a preferable aspect, the peak is preferably 55 GHz or more and 75 GHz or less, more preferably 55 GHz or more and 70 GHz or less, and still more preferably 55 GHz or more and 65 GHz or less.

As a preferable aspect, the peak is preferably 60 GHz or more and 75 GHz or less, more preferably 60 GHz or more and 70 GHz or less, and still more preferably 60 GHz or more and 65 GHz or less.

The reflection attenuation (a reflection attenuation peak amount) at the peak frequency is preferably 10 dB or more, more preferably 20 dB or more, and still more preferably 30 dB or more. When the peak frequency and the reflection attenuation peak amount are within the above-described ranges, an absorption performance suitable for a desired application can be obtained.

The electromagnetic wave absorber desirably has a peak in frequency properties of transmission attenuation. A peak frequency of the transmission attenuation is preferably 50 GHz or more and 75 GHz or less, more preferably 55 GHz or more and 70 GHz or less, and still more preferably 60 GHz or more and 65 GHz or less.

As a preferable aspect, the peak is preferably 50 GHz or more and 70 GHz or less, and more preferably 50 GHz or more and 65 GHz or less.

As a preferable aspect, the peak is preferably 55 GHz or more and 75 GHz or less, more preferably 55 GHz or more and 70 GHz or less, and still more preferably 55 GHz or more and 65 GHz or less.

As a preferable aspect, the peak is preferably 60 GHz or more and 75 GHz or less, more preferably 60 GHz or more and 70 GHz or less, and still more preferably 60 GHz or more and 65 GHz or less.

The transmission attenuation (a transmission attenuation peak amount) at the peak frequency is preferably 10 dB or more, more preferably 20 dB or more, and still more preferably 30 dB or more. When the peak frequency and the transmission attenuation peak amount are within the above-described ranges, an absorption performance suitable for a desired application can be obtained. The reflection attenuation and the transmission attenuation are measured by the free-space method. Specifically, the measurement may be performed by a method in examples to be described later or a method based thereon.

Applications of the electromagnetic wave absorber are not limited as long as the electromagnetic wave absorber is intended to absorb electromagnetic waves. For example, the electromagnetic wave absorber is applied to a transmission line, a high-frequency circuit, an electronic component, and/or an electronic device. The electromagnetic wave absorber according to the present embodiment exhibits excellent electromagnetic wave absorption performance in the millimeter wave bandwidth (30 GHz or more and 300 GHz or less). Therefore, it is particularly suitable for electromagnetic wave absorption applications in the millimeter wave bandwidth, for example, applications such as high-speed wireless LAN and collision prevention radar.

### EXAMPLES

The present invention will be described in more detail using the following examples and comparative examples. However, the present invention is not limited to the following examples.

### (1) Preparation of Ferrite Powder and Ferrite Resin Composite

### [Example 1]

### <Mixing of Raw Materials>

Iron oxide (Fe₂O₃), strontium carbonate (SrCO₃), zirconium oxide (ZrO₂), and aluminum oxide (Al₂O₃) were used as raw materials, and were weighed to have a ratio of Fe₂O₃ of 60.4 mol%, SrCO₃ of 15.3 mol%, ZrO₂ of 6.7 mol%, and Al₂O₃ of 17.6 mol%. Next, water was added to the weighed raw materials, followed by being finely pulverized using a wet bead mill including zirconia beads of 0.65 mmφ to obtain a slurry.

### <Granulation>

Polyvinyl alcohol (PVA, 15% aqueous solution) as the binder, an acrylic copolymer ammonium salt (BASF, AA-4040, 40% aqueous solution) as a dispersant, and an ammonia aqueous solution (25% aqueous solution) as a pH adjuster were added to the obtained slurry. At this time, an addition amount of the binder (the PVA) was 1 mass% in terms of solid content, and an addition amount of the dispersant (the acrylic copolymer ammonium salt) was 0.3 mass% in terms of solid content. A concentration (a solid content) of the obtained slurry was 55 mass%. Thereafter, the slurry to which the binder, the dispersant, and the pH adjuster were added was subjected to spray granulation using the spray dryer to obtain the granulated product. The average particle diameter of the obtained granulated product was 60 µm.

### <Sintering>

Next, the obtained granulated product was sintered to obtain the sintered product. The sintering was performed under conditions of 1260°C for 5 hours in an atmosphere having an oxygen (O₂) concentration of 0.0 volume%. Thereafter, the obtained sintered product was pulverized with a hammer mill to obtain a sintered powder having an average particle diameter of 14.1 µm. In this way, the ferrite powder was prepared. Production conditions of the ferrite powders are summarized in Table 1 below.

### <Preparation of Composite>

90 parts by mass of the filler (the ferrite powder) and 10 parts by mass of the binder resin were mixed and kneaded to prepare the ferrite resin composite material. At this time, a powdery fluororesin was used as the binder resin. Mixing was performed with a sample mill. Next, the obtained ferrite resin composite material was filled in a mold and heated at 180°C for 2 hours while being pressure-molded by a press machine to prepare the resin molded article. An obtained sheet (the resin molded article) had a thickness of 3 mm. The obtained sheet was used for evaluation as the ferrite molded article (the ferrite resin composite).

### [Examples 2 to 6 and Comparative Examples 1 to 6]

A mixing ratio of the raw materials (Fe₂O₃, SrCO₃, ZrO₂, and Al₂O₃) and sintering conditions were changed as indicated in Table 1 below. The ferrite powder and the composite were prepared in the same manner as in Example 1 except for the above.

**[Table 1]**

| Table 1 Production Conditions of Ferrite Powder | | | | | | |
|---|---|---|---|---|---|---|
| | Mixing ratio | | | | Sintering conditions | |
| | Fe₂O₃ (mol%) | SrCO₃ (mol%) | ZrO₂ (mol%) | Al₂O₃ (mol%) | Temperature (°C) | O₂ concentration (vol%) |
| Example 1 | 60.4% | 15.3% | 6.7% | 17.6% | 1260 | 0.0 |
| Example 2 | 41.4% | 17.2% | 6.4% | 35.1% | 1240 | 0.0 |
| Example 3 | 78.2% | 14.0% | 2.6% | 5.3% | 1200 | 1.0 |
| Example 4 | 78.6% | 14.9% | 1.1% | 5.4% | 1220 | 1.0 |
| Example 5 | 82.3% | 14.8% | 0.2% | 2.8% | 1240 | 5.0 |
| Example 6 | 82.0% | 15.1% | 0.2% | 2.8% | 1240 | 10.0 |
| Comparative Example 1 | 85.7% | 14.3% | 0.0% | 0.0% | 1200 | 0.0 |
| Comparative Example 2 | 78.5% | 15.1% | 1.1% | 5.3% | 1220 | 12.0 |
| Comparative Example 3 | 40.0% | 19.1% | 0.8% | 40.1% | 1240 | 0.0 |
| Comparative Example 4 | 55.4% | 14.6% | 7.6% | 22.5% | 1000 | 1.0 |
| Comparative Example 5 | 78.3% | 14.4% | 0.5% | 6.8% | 1200 | 0.0 |
| Comparative Example 6 | 82.7% | 16.2% | 1.1% | 0.0% | 1260 | 0.0 |

### (2) Evaluation

Various properties of the ferrite powders and the composites obtained in Examples 1 to 6 and Comparative Examples 1 to 6 were evaluated as follows.

### <Chemical Analysis>

The contents of Fe, Sr, Al, and Zr in the ferrite powder were measured by ICP emission spectrometry. Specifically, 0.2 g of the ferrite powder to be measured was weighed. Then, 20 ml of 1N hydrochloric acid and 20 ml of 1N nitric acid were added to 60 ml of pure water and heated, and the weighed ferrite powder was added thereto and completely dissolved to prepare an aqueous solution. The prepared aqueous solution was used as a measurement sample, and a sample was set in an ICP emission spectrometer (ICPS-1000IV manufactured by Shimadzu Corporation) to measure the contents of Fe, Sr, Al, and Zr.

### <Oxidation-Reduction Titration>

The Fe²⁺ amount in the ferrite powder was determined by oxidation-reduction titration with a potassium permanganate solution. The oxidation-reduction titration was performed according to JIS M 8213-1995, and the potassium permanganate solution was used instead of a potassium dichromate solution.

### <XRD>

A powder X-ray diffraction pattern was obtained using the ferrite powder as the sample, and the obtained pattern was subjected to Rietveld analysis to determine a content of each crystal phase (an M-type ferrite phase and an Fe₂O₃ phase) in the ferrite powder. It may be less likely to identify and quantify each crystal phase in a waveform separation of the powder X-ray diffraction pattern, but it is possible to identify and quantify each phase by Rietveld analysis based on a crystal structure model.

As an X-ray diffraction device, "X'PertPRO MPD", manufactured by PANalytical was used. A Co tube (a CoKα ray) was used as an X-ray source. A focusing optical system and a high-speed detector "X'Celarator" were used as an optical system. Measurement conditions are as follows.

### -Scanning speed: 0.08 °/sec

- Divergence slit: 1.0°
- Scattering slit: 1.0°
- Receiving slit: 0.15 mm
- Voltage and current values of sealed tube: 40 kV/40 mA
- Measurement range: 2θ = 15° to 90°
- Integration number: 5 times

Based on the obtained measurement results, a crystal structure was identified as follows.
·Magnetoplumbite-type ferrite (M-type ferrite)
Space group: P63/mmc (No. 194)
·Iron oxide (Fe₂O₃)
Space group: R-3c (No. 167)

Next, the following parameters were optimized using analysis software "RIETAN-FP v2.83", and the contents of M-type ferrite and Fe₂O₃ in the ferrite powder were determined based on the optimized results. When optimizing, as a profile function, a pseudo-Voigt function of Thompson, Cox, Hasting was used, and asymmetrization was used by a Howard method. In addition, the following parameters were optimized such that the Rwp value and the S value, each representing the fitting accuracy, were Rwp: 2% or less and S: 1.5 or less, respectively.

### (Parameters to be Optimized)

- Shift factor
- Scale factor
- Background parameter
- Gaussian function U, V, and W
- Lorentz function X and Y
- Asymmetry parameter As
- Lattice Constant
- Atomic Coordinates

### <Composition Formula>

Using the contents of Fe, Sr, Al, and Zr obtained by chemical analysis, the content of divalent iron ions (Fe²⁺) obtained by oxidation-reduction titration, and the content of each crystal phase (the M-type ferrite and Fe₂O₃) obtained by XRD, the composition formula (Sr(FeₓAl_{y}Zr_{z})₁₂O_{19+δ}) of the M-type ferrite contained in the ferrite powder was obtained according to the following procedure.

When the Fe amount (A mass%), the Sr amount (B mass%), the Al amount (C mass%), and the Zr amount (D mass%) in terms of mass fraction determined by the chemical analysis are converted into molar fractions, corresponding A' (mol%), B' (mol%), C' (mol%), and D' (mol%) are determined. Specifically, using a molar mass of Fe (55.845 g/mol), a molar mass of Sr (87.62 g/mol), a molar mass of Al (26.9815 g/mol), and a molar mass of Zr (91.224 g/mol), the Fe amount A' (mol%), the Sr amount B' (mol%), the Al amount C' (mol%), and the Zr amount D' (mol%) in terms of molar fraction are determined according to the following formulas (1) to (4).$A ′ = \left(A/55.845\right) / \left(A/55.845+B/87.62+C/26.9815+D/91.224\right) \times 100$ (1) $B ′ = \left(B/87.62\right) / \left(A/55.845+B/87.62+C/26.9815+D/91.224\right) \times 100$ (2) $C ′ = \left(C/26.9815\right) / \left(A/55.845+B/87.62+C/26.9815+D/91.224\right) \times 100$ (3) $D ′ = \left(D/91.224\right) / \left(A/55.845+B/87.62+C/26.9815+D/91.224\right) \times 100$ (4)

When an abundance (a mass fraction) of the two phases of the magnetoplumbite (M) type ferrite and Fe₂O₃ is converted into the molar fraction, the content (mol%) of Fe constituting the M-type ferrite is obtained. For example, an M-type ferrite amount is α, (mass%), and an Fe₂O₃ amount is β (mass%). When the composition formula SrFe₁₂O₁₉ is used as an example of the M-type ferrite, the M-type ferrite amount α' (mol%) and the Fe₂O₃ amount β' (mol%) in terms of molar fraction are obtained according to the following formulas (5) and (6) using a molar mass (1061. 7486 g/mol) of SrFe₁₂O₁₉ and a molar mass (159. 6882 g/mol) of Fe₂O₃. $α ′ = \left(α/1061.7486\right) / \left(α/1061.7486+β/159.6882\right) \times 100$ (5) $β ′ = \left(β/159.6882\right) / \left(α/1061.7486+β/159.6882\right) \times 100$ (6)

Then, by using these values, an Fe amount γ (mol%) constituting the M-type ferrite can be determined according to the following formula (7).$γ = A ′ - A ′ \times \left(β′\times 2/\left(α′\times 12+β′\times 2\right)\right)$ (7)

Subsequently, x, y, z, and x + y + z can be calculated according to the following formulas (8) to (11) such that the composition formula is Sr(FeₓAl_{y}Zr_{z})₁₂O_{19+δ}.$x = γ / \left(B′\times 12\right)$ (8) $y = C ′ / \left(B′\times 12\right)$ (9) $z = D ′ / \left(B′\times 12\right)$ (10) $x + y + z = γ / \left(B′\times 12\right) + C ′ / \left(B′\times 12\right) + D ′ / \left(B′\times 12\right)$ (11)

When the content of Fe²⁺ is σ, and a total number of cations in the M-type ferrite is ζ, σ and ξ satisfy a relationship of the following formula (12).$ζ = 3 \times 12 \times \left(x\times \left(1-σ\right)\right) + 2 \times 12 \times \left(x\times σ\right) + 3 \times 12 \times y + 4 \times 12 \times z + 1 \times 2$ (12)

The content σ of Fe²⁺ represents the content (the mass ratio) when a total amount of the ferrite powder is 1. For example, the "Fe²⁺ content" in Example 1 is 3.52 mass% (Table 2), and the Fe²⁺ content σ is 3.52/100.

Here, since oxygen of the composition formula is deficient to satisfy an electrical neutrality condition of the M-type ferrite, an oxygen deficiency amount δ is obtained according to the following formula (13).$δ = \left(ζ/2\right) - 19$ (13)

In this way, the values of x, y, z, x + y + z, and δ in the composition formula Sr(FeₓAl_{y}Zr_{z})₁₂O_{19+δ} can be determined.

### <Volume Average Particle Diameter>

A volume average particle diameter (D50) of the ferrite powder was measured using a Microtrac particle size analyzer (Model 9320-X100, manufactured by Nikkiso Co., Ltd.). Specifically, 10 g of the ferrite powder and 80 ml of water were charged into a 100 ml beaker, and a dispersant (sodium hexametaphosphate) was added in two or three drops. Next, an obtained mixed liquid was subjected to a dispersion treatment using an ultrasonic homogenizer (SMT. Co. LTD., UH-150 type). At this time, an output level of the ultrasonic homogenizer was set to 4. The dispersion treatment was performed for 20 seconds. After the dispersion treatment, bubbles formed on a surface of the beaker were removed to prepare a measurement sample. A D50 of the obtained measurement sample was measured by the above-described particle size analyzer.

### <Volume Resistivity>

The volume resistivity of the ferrite powder was measured. First, a measurement sample was prepared by filling a fluororesin cylinder with a cross-sectional area of 4 cm² with the ferrite powder to a height of 4 mm. Next, electrodes were attached to both ends (upper and lower ends) of the measurement sample, and 1 kg of weight was placed thereon to measure the electrical resistance. In the resistance measurement, a resistance value at an applied voltage of 100 V was calculated using an electrometer (KEITHLEY, insulation resistance meter, model 6517A). The volume resistivity was calculated based on the obtained resistance value.

The volume resistivity was measured at room temperature under the atmosphere (300K).

### <Relative Permittivity>

The relative permittivity (εr) of the composite was measured by the free-space method. The measurement was performed using a network analyzer (Keysight Technology, E5253E2) and a free space measurement device (EM Laboratories, FS-330). Specifically, one port was used to irradiate the composite with an input wave (50 GHz to 75 GHz) of a predetermined frequency from a transmission and reception antenna via a dielectric lens. Then, reflective properties and transmission properties (S parameters) of the electromagnetic waves were measured, and the relative permittivity was calculated based on the obtained properties. At this time, the relative permittivity was analyzed using a Keysight material measurement suite N1500A attached to the apparatus. The analysis was performed using a Nicholson-Ross-Weir (NRW) model.

### <Filler Filling Rate>

The filler filling rate in the ferrite molded article was measured by observing a cross section of the ferrite molded article with a scanning electron microscope (SEM). Specifically, the ferrite molded article was processed to have dimensions of 5 mm × 5 mm and a thickness of 3 mm using an ion milling device (Hitachi High-Technologies Corporation, IM-4000). Next, the processed ferrite molded article was set on a stage such that a cross section thereof was on an upper side, and used as a measurement sample. Ion milling processing was performed under the following conditions.
- DISCHARGE VOLTAGE: 1.5 kV
- ACCELERATION VOLTAGE: 6 kV
- STAGE CONTROL (processing mode): C3
- DISCHARGE CURRENT (discharge current inside ion gun): 380 µA to 450 µA
- ION BEAM CURRENT: 110 µA to 140 µA
- GAS FLOW (argon gas flow rate): 0.07 cm³/min to 0.10 cm³/min
- Processing time: 60 minutes

Next, the prepared measurement sample was observed using an SEM (SU-8020 manufactured by Hitachi High-Technologies Corporation). The SEM observation was performed under conditions of an acceleration voltage of 1 kV and a magnification of 500 times to 10000 times (a magnification at which approximately 30 particles fall within one visual field), and a cross-sectional SEM image for three visual fields was captured in an LA mode. Thereafter, the obtained cross-sectional SEM image was binarized to determine the ratio of the ferrite powder, and the filler filling rate was calculated. The filler filling rate calculated as an average of the three visual fields was rounded off to the second decimal place.

### <Magnetic Properties>

The saturation magnetization (Ms), the residual magnetization (Mr), and the coercive force (Hc) of the ferrite powder were measured. Specifically, the ferrite powder was packed in a cell having an inner diameter of 5 mm and a height of 2 mm, and set in a vibrating sample magnetometer (VSM-C7-10A, manufactured by TOEI INDUSTRY CO., LTD.). An applied magnetic field was applied and swept to 10 kOe, and then the applied magnetic field was decreased to draw a hysteresis curve. The Ms, the Mr, and the Hc were read from obtained curve data.

### <Reflective Properties and Transmission Properties>

The composite was used as a sample, and the reflective properties and the transmission properties were measured by the free-space method. A network analyzer (Keysight Technology, E5253E2) and a free space measurement device (EM Laboratories, FS-330) were used as measurement devices. The S parameters were measured at an incident angle of 0° and a sweep frequency of 50 GHz to 75 GHz. Then, the peak frequency of electromagnetic wave absorption, the transmission attenuation, and the reflection attenuation at 50 GHz to 75 GHz of the composite were obtained based on the obtained S parameters. The S parameters were analyzed using a Keysight material measurement suite N1500A attached to the apparatus.

### <Bending Strength>

The bending strength (the biaxial bending strength) of the composite was measured by a method according to ISO/DIS6872. For the measurement, a sheet-shaped composite having a magnitude of 15 mm × 15 mm and a thickness of 3 mm was used. The measurement was performed three times on the composite prepared under the same conditions, and an average value thereof was defined as the biaxial bending strength.

### (3) Evaluation Results

Results obtained for the ferrite powder and the composite are summarized in Tables 2 and 3 below.

In the ferrite powders of Examples 1 to 6, the values of the composition and the volume resistivity satisfied the ranges specified in the present embodiment. Therefore, the relative permittivity was as relatively high as 10.5 or more, and the reflection attenuation in the millimeter wave bandwidth was as relatively large as 11.8 dB or more. In particular, in Examples 1 and 2, the reflection attenuation was as large as 28.9 dB or more, and the bending strength of the composite was as relatively large as 3367 MPa or more.

In contrast, in Comparative Examples 1 to 5 in which at least one of the composition and the volume resistivity did not satisfy the range specified in the present embodiment, the relative permittivity was as low as 9.8 or less. The reflection attenuation was as low as 8.1 or less.

In Comparative Example 6, the relative permittivity and the reflection attenuation satisfied the preferable ranges, but the composition and the sintering temperature did not satisfy the specified ranges. Therefore, the peak frequency of the reflection attenuation deviated from the desired frequency band of 50 GHz to 75 GHz required in the present embodiment.

### [Table 2]

**[Table 2]**

| Table 2 Properties of Ferrite Powder | | | | | | | | | | | | | | |
|---|---|---|---|---|---|---|---|---|---|---|---|---|---|---|
| | Sr(FeₓAl_{y}Zr_{z})₁₂O_{19+δ} | | | | | ICP | | | | Titration | XRD | | Particle size | Volume resistance (Ω cm) |
| | x | y | z | x + y + z | δ | Fe (mass%) | Sr (mass%) | Al (mass%) | Zr (mass%) | Fe²⁺ (mass%) | M-type ferrite (mass%) | Fe₂O₃ (mass%) | D50 (µm) | |
| Example 1 | 0.651 | 0.191 | 0.036 | 0.879 | -1.79 | 49.9 | 8.9 | 6.3 | 4.0 | 3.52 | 92 | 8 | 14.1 | 6.8 × 10⁶ |
| Example 2 | 0.401 | 0.344 | 0.031 | 0.776 | -3.35 | 48.8 | 11.8 | 15.0 | 4.5 | 3.99 | 82 | 18 | 8.4 | 2.4 × 10⁷ |
| Example 3 | 0.909 | 0.062 | 0.015 | 0.987 | -1.04 | 74.6 | 8.0 | 1.8 | 1.5 | 1.39 | 73 | 27 | 22.9 | 7.9 × 10⁷ |
| Example 4 | 0.877 | 0.060 | 0.006 | 0.943 | -0.97 | 59.8 | 8.4 | 1.9 | 0.6 | 0.57 | 96 | 4 | 20.9 | 1.2 × 10⁸ |
| Example 5 | 0.930 | 0.032 | 0.001 | 0.962 | -0.67 | 62.3 | 8.6 | 1.0 | 0.1 | 0.07 | 98 | 2 | 34.1 | 5.2 × 10⁸ |
| Example 6 | 0.917 | 0.031 | 0.001 | 0.949 | -0.90 | 62.1 | 8.7 | 1.0 | 0.1 | 0.07 | 98 | 2 | 4.6 | 9.2 × 10⁸ |
| Comparative Example 1 | 1.000 | 0.000 | 0.000 | 1.000 | 0.00 | 66.2 | 8.7 | 0.0 | 0.0 | 0.00 | 100 | 0 | 2.8 | 2.6 × 10⁹ |
| Comparative Example 2 | 0.866 | 0.060 | 0.006 | 0.933 | -1.15 | 59.1 | 8.4 | 1.9 | 0.6 | 0.57 | 96 | 4 | 37.2 | 1.8 × 10⁹ |
| Comparative Example 3 | 0.345 | 0.351 | 0.003 | 0.699 | -5.26 | 33.5 | 12.1 | 15.7 | 0.5 | 0.46 | 98 | 2 | 5.6 | 1.5 × 10⁹ |
| Comparative Example 4 | 0.620 | 0.251 | 0.043 | 0.914 | -1.55 | 66.5 | 9.2 | 8.6 | 5.0 | 4.37 | 67 | 33 | 8.2 | 1.1 × 10⁹ |
| Comparative Example 5 | 0.915 | 0.078 | 0.003 | 0.997 | -0.03 | 61.0 | 8.5 | 2.4 | 0.3 | 0.28 | 98 | 2 | 21.7 | 1.7 × 10⁹ |
| Comparative Example 6 | 0.834 | 0.000 | 0.006 | 0.839 | -2.86 | 61.4 | 9.2 | 0.0 | 0.6 | 0.57 | 96 | 4 | 14.2 | 9.5 × 10⁸ |

### [Table 3]

**[Table 3]**

| Table 3 Properties of Ferrite Powder and Composite | | | | | | | | | | |
|---|---|---|---|---|---|---|---|---|---|---|
| | Relative permittivity εr | Filler filling rate (vol%) | Magnetic properties (VSM@10k) | | | Reflective properties | | Transmission properties | | Composite bending strength (MPa) |
| | | | Saturation magnetization Ms (emu/g) | Residual magnetization Mr (emu/g) | Coercive force Hc (Oe) | Frequency (GHz) | Attenuation (dB) | Frequency (GHz) | Attenuation (dB) | |
| Example 1 | 18.0 | 93.9 | 24 | 20 | 3617 | 63.2 | 31.6 | 64.1 | 24.9 | 3555 |
| Example 2 | 16.4 | 91.4 | 20 | 18 | 4931 | 73.5 | 28.9 | 74.9 | 21.0 | 3367 |
| Example 3 | 11.6 | 85.0 | 33 | 25 | 1951 | 52.3 | 20.3 | 53.8 | 24.7 | 2417 |
| Example 4 | 10.9 | 88.5 | 41 | 24 | 2243 | 52.4 | 14.6 | 53.9 | 24.2 | 2607 |
| Example 5 | 10.7 | 76.0 | 47 | 26 | 3123 | 50.0 | 11.9 | 51.0 | 23.8 | 1286 |
| Example 6 | 10.5 | 74.4 | 47 | 26 | 3765 | 50.5 | 11.8 | 51.0 | 23.7 | 1208 |
| Comparative Example 1 | 4.7 | 60.9 | 53 | 36 | 2908 | 45.3 | 5.4 | 40.8 | 16.0 | 910 |
| Comparative Example 2 | 7.8 | 53.5 | 41 | 31 | 4056 | 52.9 | 3.7 | 54.3 | 19.0 | 780 |
| Comparative Example 3 | 8.7 | 80.2 | 15 | 13 | 6230 | 76.0 | 4.1 | 76.4 | 6.8 | 1763 |
| Comparative Example 4 | 9.8 | 89.5 | 9 | 18 | 1756 | 45.9 | 4.8 | 41.4 | 21.1 | 2462 |
| Comparative Example 5 | 9.4 | 86.3 | 38 | 23 | 2243 | 54.5 | 8.1 | 55.9 | 19.2 | 2918 |
| Comparative Example 6 | 10.3 | 92.4 | 43 | 27 | 1549 | 46.2 | 11.7 | 41.6 | 18.0 | 3214 |

From the above results, it can be seen that according to the present embodiment, a magnetoplumbite-type hexagonal ferrite powder from which an electromagnetic wave absorber indicating an excellent electromagnetic wave absorption performance in a millimeter wave bandwidth despite having a thickness equivalent to that in the conventional art is provided.

### INDUSTRIAL APPLICABILITY

According to the present invention, a magnetoplumbite-type hexagonal ferrite powder from which an electromagnetic wave absorber indicating an excellent electromagnetic wave absorption performance in a millimeter wave bandwidth despite having a thickness equivalent to that in the conventional art is provided. A ferrite resin composite material containing the ferrite powder, a ferrite resin composite, and an electromagnetic wave absorber are provided.

The present invention has been described in detail with reference to the specific embodiment, but it is apparent to those skilled in the art that various changes and modifications can be made without departing from the spirit and scope of the present invention.

The present application is based on a Japanese patent application (Japanese Patent Application No. 2023-221337) filed on December 27, 2023, and the contents thereof are incorporated herein by reference.

## Claims

1. A ferrite powder comprising:
as a main component compound, a magnetoplumbite-type hexagonal ferrite having a composition represented by a formula of Sr(FeₓAl_{y}Zr_{z})₁₂O_{19+δ} (where x, y, z, and δ satisfy 0.400 ≤ x <1.000, 0.030 ≤ y ≤ 0.350, 0.001 ≤ z ≤ 0.040, 0.750 ≤ x + y + z <1.000, and -5.00 ≤ δ ≤ -0.200), wherein
the ferrite powder has a volume resistivity of 1.0 × 10⁹ Ω·cm or less.

2. The ferrite powder according to claim 1, wherein
the ferrite powder has an average particle diameter of 3 µm or more and 35 µm or less.

3. The ferrite powder according to claim 1 or 2, wherein
a content of each of strontium (Sr), aluminum (Al), and zirconium (Zr) is as follows:
Sr is 8.0 mass% or more and 12 mass% or less,
Al is 1.0 mass% or more and 15 mass% or less, and
Zr is 0.10 mass% or more and 4.5 mass% or less.

4. The ferrite powder according to claim 1 or 2, wherein
a content of divalent iron ions (Fe²⁺) is 0.05 mass% or more and 4.0 mass% or less.

5. A ferrite resin composite material comprising:
the ferrite powder according to claim 1 or 2; and
a resin.

6. A ferrite resin composite that is a molded article of the ferrite resin composite material according to claim 5.

7. An electromagnetic wave absorber comprising:
the ferrite resin composite according to claim 6.
